# EUROPEAN PATENT APPLICATION

(11) **EP 4 458 607 A1**
(43) Date of publication of application: **06.11.2024**
(21) Application number: 23171415.5
(22) Date of filing: 03.05.2023
(51) Int. Cl.: B60L 58/10, B60L 3/00

(54) **VEHICLE BATTERY CELL COUNTERFEIT DETECTION**

(71) Applicant: VOLVO TRUCK CORPORATION, 405 08 Göteborg (SE)
(72) Inventor: Lidström, Emil, 423 56 TORSLANDA (SE)
(74) Representative: Ström & Gulliksson AB

(57) **Abstract**

A computer system comprising processing circuitry configured to receive sensor-obtained battery data (60) from at least one battery cell (26) being monitored by a battery management system (20) of a vehicle (10), the at least one battery cell (26) being of a particular type; obtain battery reference data (72) from a plurality of battery reference cells (76) of different types; compare the sensor-obtained battery data (60) to the battery reference data (72), wherein a battery cell modeler (70) is configured to perform the comparing by processing the sensor-obtained battery data (60) and the battery reference data (72); and based on the comparing, determine counterfeit characteristics data (90) indicating that said particular type of the at least one battery cell (26) deviates from a selected type among said plurality of reference battery cells (76) of different types.

## Description

### TECHNICAL FIELD

The disclosure relates generally to vehicle energy storage systems. In particular aspects, the disclosure relates to prevention of counterfeiting of battery cells in vehicles. The disclosure can be applied to heavy-duty vehicles, such as trucks, buses, and construction equipment, among other vehicle types. Although the disclosure may be described with respect to a particular vehicle, the disclosure is not restricted to any particular vehicle.

### BACKGROUND

In view of the ongoing technological advancement of electric vehicles, the number of electric vehicle batteries are continuously increasing. Given the sheer amount of batteries arranged in today's electric vehicles, there is a significant risk of said batteries being tampered with once the vehicle is out on the aftermarket. More specifically, vehicle workshops and other third parties are seeing great potential in providing counterfeit battery cells by replacing, changing and/or to some extent modifying the existing batteries for their own winnings. Counterfeiting of battery cells can lead to devastating losses, as the vehicle may continue to operate under unsafe operating conditions, according to the vehicle manufacturer's safety and regulatory standards, without the driver necessarily knowing about it. Such losses involve safety hazards for the driver and anyone being in the vicinity of the vehicle. Moreover, the performance of a battery management system (BMS) designed to monitor the battery cells may be degraded as said battery cells are no longer recognizable. It is therefore desired to detect counterfeit battery cells of a vehicle battery.

### SUMMARY

According to a first aspect of the disclosure, a computer system comprising processing circuitry is provided. The processing circuitry is configured to receive sensor-obtained battery data from at least one battery cell being monitored by a battery management system of a vehicle, the at least one battery cell being of a particular type; obtain battery reference data from a plurality of battery reference cells of different types; compare the sensor-obtained battery data to the battery reference data, wherein a battery cell modeler is configured to perform the comparing by processing the sensor-obtained battery data and the battery reference data; and based on the comparing, determine counterfeit characteristics data indicating that said particular type of the at least one battery cell deviates from a selected type among said plurality of reference battery cells of different types. The first aspect of the disclosure may seek to detect counterfeit battery cells of a vehicle battery. A technical benefit may include accurate detection of counterfeit battery cells of a vehicle battery. The first aspect of the disclosure is cost and space effective since it can utilize existing vehicle sensors to assess information thereof. Moreover, the first aspect of the disclosure is not particularly complex since no modifications are required to the batteries or packs thereof. In addition, the battery packs need not be opened in order to determine whether a cell is counterfeited, which saves significant time.

Optionally in some examples, including in at least one preferred example, the processing of the sensor-obtained battery data and the battery reference data comprises performing a time series analysis on time series data included in the sensor-obtained battery data. A technical benefit may include taking into account the lifetime cycle of the battery cell such that anomalies caused by e.g., replacement of a battery cell can be quickly identified.

Optionally in some examples, including in at least one preferred example, the time series analysis comprises creating a first electrochemical fingerprint based on the time series data included in the sensor-obtained battery data, creating a second electrochemical fingerprint based on reference time series data included in the battery reference data of said selected type among said plurality of reference battery cells of different types, said selected type being correlated to the at least one battery cell from which the sensor-obtained battery data was obtained. A technical benefit may include basing the identification on electrochemical properties of the time series analysis such that battery counterfeit cells can be detected more efficiently.

Optionally in some examples, including in at least one preferred example, the comparing of the first and second electrochemical fingerprints comprises detecting deviations exceeding a predefined threshold value. A technical benefit may include being able to adjust the hit rate of the comparison against a threshold value such that more adaptability can be achieved in the comparison.

Optionally in some examples, including in at least one preferred example, the battery cell modeler is a neural network. A technical benefit may include intelligent features of the neural network to accurately determine a counterfeited battery cell.

Optionally in some examples, including in at least one preferred example, the neural network is configured to periodically receive input data, the input data comprising updated battery reference data of already stored types of said reference battery cells, and new battery reference data from additional different types of reference battery cells, perform a training procedure by processing the periodically received input data, and determine the counterfeit characteristic data taking into account said performed training procedure. A technical benefit may include adapting the neural network to new or additional data to improve its identification accuracy.

Optionally in some examples, including in at least one preferred example, the updated battery reference data and the new battery reference data are periodically received from sample counterfeit cells. A technical benefit may include being able to customize the neural network depending on circumstances.

Optionally in some examples, including in at least one preferred example, the battery reference data comprises brand information indicating what brand the reference battery cells of different types are associated with. A technical benefit may include being able to associate a battery cell with a particular battery cell brand to gain more knowledge of the counterfeited cell.

Optionally in some examples, including in at least one preferred example, each one of the sensor obtained battery data and the battery reference data, respectively, is selected from a group comprising voltage data, current data, resistance data, temperature data, capacity data and electrochemical spectroscopy data. A technical benefit may being able to compare many different data types to obtain a versatile identification procedure.

Optionally in some examples, including in at least one preferred example, the battery cell modeler is comprised in a cloud-based computing resource external to the vehicle. A technical benefit may include utilizing the cloud to perform heavy calculations that may otherwise not function as well in case they were to performed in-vehicle. Another technical benefit may include being able to use more data from a complete vehicle fleet and use said more data to take improved decisions, since the cloud-based computing resource is configurable with a plurality of vehicles connected to the vehicle fleet.

Optionally in some examples, including in at least one preferred example, the cloud-based computing resource is configured to transmit the counterfeit characteristics data to either one or both of a vehicle telematics unit arranged in the vehicle and a central server. A technical benefit may include remote communication and reporting of data and/or results.

According to a second aspect of the disclosure, a vehicle comprising the computer system of the first aspect is provided. The second aspect of the disclosure may seek to detect counterfeit battery cells of a vehicle battery. The second aspect of the disclosure is cost and space effective since it can utilize existing vehicle sensors to assess information thereof. Moreover, the second aspect of the disclosure is not particularly complex since no modifications are required to the batteries or packs thereof. In addition, the battery packs need not be opened in order to determine whether a cell is counterfeited, which saves significant time.

According to a third aspect of the disclosure, a computer-implemented method for vehicle battery cell counterfeit detection is provided. The method comprises receiving, by processing circuitry of a computer system, sensor-obtained battery data from at least one battery cell being monitored by a battery management system of a vehicle, the at least one battery cell being of a particular type; obtaining, by the processing circuitry, battery reference data from a plurality of battery reference cells of different types; comparing, by the processing circuitry, the sensor-obtained battery data to the battery reference data, wherein the comparing is performed by a battery cell modeler being configured to process the sensor-obtained battery data and the battery reference data; and based on the comparing, determining, by the processing circuitry, counterfeit characteristics data indicating that said particular type of the at least one battery cell deviates from a selected type among said plurality of reference battery cells of different types. The third aspect of the disclosure may seek to detect counterfeit battery cells of a vehicle battery. The third aspect of the disclosure is cost and space effective since it can utilize existing vehicle sensors to assess information thereof. Moreover, the third aspect of the disclosure is not particularly complex since no modifications are required to the batteries or packs thereof. In addition, the battery packs need not be opened in order to determine whether a cell is counterfeited, which saves significant time.

According to a fourth aspect of the disclosure, a computer program product is provided. The computer program product comprises program code for performing, when executed by the processing circuitry, the method of the third aspect. The fourth aspect of the disclosure may seek to detect counterfeit battery cells of a vehicle battery. The fourth aspect of the disclosure is cost and space effective since it can utilize existing vehicle sensors to assess information thereof. Moreover, the fourth aspect of the disclosure is not particularly complex since no modifications are required to the batteries or packs thereof. In addition, the battery packs need not be opened in order to determine whether a cell is counterfeited, which saves significant time.

According to a fifth aspect of the disclosure, a non-transitory computer-readable storage medium is provided. The non-transitory computer-readable storage medium comprises program code for performing, when executed by the processing circuitry, the method of the third aspect. The fifth aspect of the disclosure may seek to detect counterfeit battery cells of a vehicle battery. The fifth aspect of the disclosure is cost and space effective since it can utilize existing vehicle sensors to assess information thereof. Moreover, the fifth aspect of the disclosure is not particularly complex since no modifications are required to the batteries or packs thereof. In addition, the battery packs need not be opened in order to determine whether a cell is counterfeited, which saves significant time.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

### BRIEF DESCRIPTION OF THE DRAWINGS

Examples are described in more detail below with reference to the appended drawings.
**FIG. 1** is an exemplary system diagram of a heavy-duty vehicle according to one example.
**FIG. 2** is an exemplary schematic block diagram visualizing data being used by the heavy-duty vehicle for determining counterfeit characteristics data according to one example.
**FIG. 3** is an exemplary schematic block diagram visualizing exemplary sensor-obtained battery data and battery reference data.
**FIG. 4** is an exemplary schematic block diagram visualizing the determination of counterfeit characteristics data based on electrochemical fingerprints according to one example.
**FIG. 5** is an exemplary illustration visualizing electrochemical fingerprint deviations according to one example.
**FIG. 6A** illustrate an exemplary battery cell modeler and exemplary data used by said battery cell modeler according to one example.
**FIG. 6B** illustrate an exemplary battery cell modeler and exemplary data used by said battery cell modeler according to one example.
**FIG. 7** is an exemplary schematic flowchart illustration of a method according to one example.
**FIG. 8** is a schematic diagram of a computer system for implementing examples disclosed herein according to one example.

### DETAILED DESCRIPTION

The detailed description set forth below provides information and examples of the disclosed technology with sufficient detail to enable those skilled in the art to practice the disclosure.

As indicated in the above Background section, in prior art vehicles there are significant risks of batteries being tampered with once the vehicles are out on the aftermarket. The present disclosure provides an insightful approach of determining counterfeit characteristics data by way of comparing sensor-obtained battery data of a vehicle battery cell of a particular type with battery reference data of a plurality of battery reference cells. Various deviations exhibited in the data of the vehicle battery cell can be compared to reference data being indicative of how that particular vehicle battery cell is expected to be behaving. By identifying anomalies, it can be established whether said vehicle battery cell is a counterfeit cell. By knowing whether vehicle battery cells are counterfeited or not, safe operating conditions can be assured according to the vehicle manufacturer's safety and regulatory standards. In addition, the performance of the BMS designed to monitor the battery cells will be reliable since it can correctly assess the recognizable battery cells.

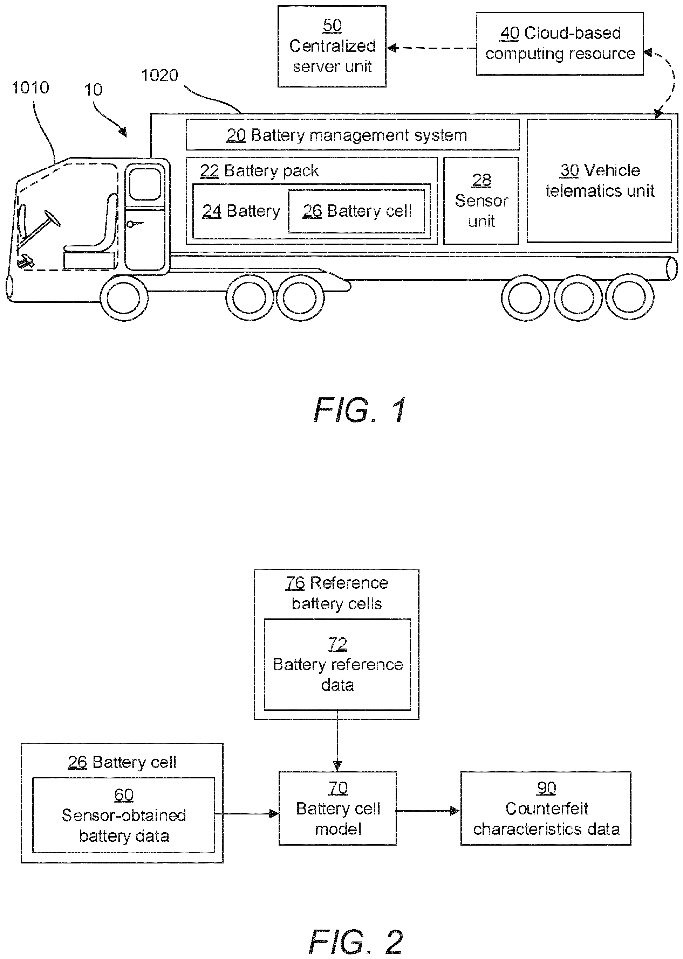

**FIG. 1** is an exemplary schematic illustration of a heavy-duty vehicle **10** (hereinafter referred to vehicle **10** for reasons of brevity). This particular vehicle **10** comprises a tractor unit **1010** which is arranged to tow a trailer unit **1020.** In other examples, other heavy-duty vehicles may be employed, e.g., trucks, buses, and construction equipment. Although not explicitly visualized in the figure, the skilled person will appreciate that the vehicle **10** comprises all necessary vehicle units and associated functionality such that it may operate as the skilled person would expect of a vehicle **10.** Emphasis in the present disclosure is instead directed at battery cell counterfeit detection, as will now be discussed.

The vehicle **10** comprises a battery management system **20.** The battery management system **20** is configured to carry out a wide range of functionalities associated with at least one battery pack **22** of the vehicle **10.** Such wide range of functionalities may vary depending on the type of vehicle **10** and its operating conditions, but generally includes one or more of battery monitoring, battery protection, battery operational state estimation, battery performance optimization and battery operation status reporting. These actions are carried out with respect to the battery pack **22.**

The battery pack **22** is arranged in the vehicle **10** and adapted to power electrical machines (not shown) of the vehicle **10,** such as motors. Each battery pack **22** comprises at least one battery **24.** Each battery **24** comprises one or more battery cells **26.** Each battery cell **26** comprises a single anode and cathode separated by electrolyte that is used to produce a voltage and current. The battery management system **20** is configured to monitor the one or more battery cells **26.** Different types of batteries **24** comprise various numbers of battery cells **26.** Moreover, the battery cells **26** may be of different types for different types of batteries **24.** By way of example, a lithium-ion battery may comprise three cells to provide an 11.1 V battery, four cells to provide a 14.8 V battery, or 10 cells to provide a 37 V battery. Hence, the number and/or type of battery cells **26** may determine the amount of voltage and current being produced, which is consequently being monitored by the battery management system **20.** Provided by such monitoring of voltage and current, it is possible to recognize what type of battery cells **26** that are included in a particular battery **24.** In some examples, other types of battery cells **26** making up other batteries **24** may be realized, such as lead-acid batteries or nickel-metal hydride batteries. The functionalities explained above associated with the battery management system **20** may be applied to either the entirety of the at least one battery pack **22,** portions thereof (e.g., one or more individual batteries **24**), or even individual battery cells **26.** The present disclosure is not limited to any number or types of battery packs **22,** batteries **24** or battery cells **26.**

The vehicle **10** comprises at least one sensor unit **28.** The sensor unit **28** is arranged to provide measurements of the battery pack **22.** More specifically, the sensor unit **28** is arranged to provide measurements of batteries **24.** Even more specifically, the sensor unit **28** is arranged to provide measurements of individual battery cells **26** of the batteries **24.** A single sensor unit **28** may be configured to provide measurements from one or more cells **26,** batteries **24** or packs **22.** Alternatively, one sensor unit **28** may be arranged and configured in operation with a respective cell **26.** To this end, the vehicle **10** may comprise a plurality of sensor units **28,** each sensor unit **28** being arranged at a respective battery **24** or cell **26** thereof. Hence, the sensor unit **28** is configured to obtain battery data from the battery cells **26** being monitored by the battery management system **20** of the vehicle **10,** wherein the battery cells **26** may be of a particular type.

The sensor unit **28** may be any type of sensor capable of providing sensor-obtained battery data to the battery management system **20.** The sensor unit **28** may be of different sensor types, including but not limited to voltage sensors, current sensors, temperature sensors, electrochemical sensors, State of Charge (SoC) sensors, State of Health (SoH) sensors, gas sensors, pressure sensors, humidity sensors, accelerometers, optical sensors, magnetic sensors, or ultrasonic sensors. The sensor unit **28** may be configured as a combination of one or more of these various sensor types. Different sensor units **28** may be realized as one or more of these mentioned sensor types.

The vehicle **10** comprises a vehicle telematics unit **30.** The vehicle telematics unit **30** is configured for obtaining data from the vehicle **10,** more specifically from the battery management system **20,** and communicate said data wirelessly to an external service. The sensor-obtained battery data may be transmitted from the vehicle telematics unit **30** to a cloud-based computing resource **40** during an ongoing operation of the vehicle **10,** i.e., in online mode. The operation of the vehicle **10** may be a particular usage of the vehicle **10,** such as a start-up at a first location, a drive to a second location, and a shutdown at said second location. Such online data transmission may be realized in at least near real-time, where at least near real-time is to be interpreted as involving some minor delay caused by, for instance, network connectivity, latencies, or other similar reasons. In some examples, batch processing and transfer of the data may be realized. In this particular example, the vehicle telematics unit **30** is configured to be in communication with a cloud-based computing resource **40.** The communication may be based on any known short-range or long-range standards or protocols known in the art. The following list of examples are some exemplary network/radio communication standards or protocols that may be employed by the vehicle telematics unit **30** and the cloud-based computing resource **40**: HTTP(S), TCP/IP, UDP, FTP, SMTP, DNS, DHCP, SSH, POP3, SCP, NFS, SFTP, ICMP, ARP, RTP, RTCP IEEE 802.11, IEEE 802.15, ZigBee, WirelessHART, WiFi, Bluetooth^{®}, BLE, RFID, WLAN, MQTT IoT, CoAP, DDS, NFC, AMQP, LoRaWAN, Z-Wave, Sigfox, Thread, EnOcean, mesh communication, any form of proximity-based device-to-device radio communication, LTE Direct, W-CDMA/HSPA, GSM, UTRAN, LTE, IPv4, IPv6, 6LoWPAN, IrDA, or 5GNR.

The cloud-based computing resource **40** may be implemented using any commonly known cloud-computing platform technologies, such as e.g. Amazon Web Services, Google Cloud Platform, Microsoft Azure, DigitalOcean, Oracle Cloud Infrastructure, IBM Bluemix or Alibaba Cloud. The cloud-based computing resource **40** may be included in a distributed cloud network that is widely and publically available, or alternatively limited to an enterprise. The cloud-based computing resource **40** may comprise a cloud-based storage unit. The cloud-based storage unit may be included with or external to the cloud-based computing resource **40.** Connection to the cloud-based storage unit may be established using DBaaS (Database-as-a-service). For instance, the cloud-based storage unit may be deployed as a SQL data model such as MySQL, PostgreSQL or Oracle RDBMS. Alternatively, deployments based on NoSQL data models such as MongoDB, Amazon DynamoDB, Hadoop or Apache Cassandra may be used. DBaaS technologies are typically included as a service in the associated cloud-based computing resource **40.**

The cloud-based computing resource **40** may be in further communication with a centralized server unit **50.** Communication between the cloud-based computing resource **40** and the centralized server unit **50** may be realized by any of the communication standards or protocols as mentioned above with respect to the cloud-based computing resource **40** and the vehicle telematics unit **30.** The centralized server unit **50** may be configured for collecting and analyzing data from a plurality of vehicles, and subsequently provide new and/or updated data to said plurality of vehicles based on various factors such as new battery types or characteristics.

In some examples, the sensor-obtained battery data is not necessarily transferred from the vehicle telematics unit **30** to the centralized server unit **50** during an ongoing operation of the vehicle **10.** Instead, the sensor-obtained battery data may be transferred in an offline fashion after the vehicle **10** has finished an operation. Hence, the vehicle telematics unit **30** is configured to store sensor-obtained battery data during the operation, but the transfer is not effected until after said operation is completed. This may be realized in certain situations, such as at vehicle workshops or other vehicle maintenance locations.

**FIG. 2** is an exemplary schematic block diagram visualizing data being used by the vehicle **10** for determining counterfeit characteristics data **90.** Sensor-obtained battery data **60** is obtained from the battery cell **26** that is being inspected for being a potential counterfeit product. This may be done using any of the sensors as discussed above with reference to **FIG. 1****.** The sensor-obtained battery data **60** may be obtained in real-time during an ongoing operation of the vehicle **10,** and, for instance, transmitted via the vehicle telematics unit **30** to the cloud-based computing resource **40** for analysis thereof. Alternatively, the sensor-obtained battery data **60** may be sent after an operation of the vehicle **10.** In addition, battery reference data **72** is obtained from a plurality of reference battery cells **76.** The reference battery cells **76** may be of the same particular type or alternatively of a plurality of different types, and are to be interpreted as the "comparison objects". Hence, the sensor-obtained battery data **60** of the battery cell **26** is compared against the comparison objects being the battery reference data **72** of the reference battery cells **76.** The objective of the comparison is to identify potential deviations there between, wherein said potential deviations may be indicative of the battery cell **26** being counterfeited. The potential deviations are indicated by the counterfeit characteristics data **90.**

The term "counterfeit characteristics data" **90** is to be interpreted as informational data indicating how and to what extent the battery cell **26** differs from and/or is similar to the one or more reference battery cells **76.** In the simplest of examples, the counterfeit characteristics data **90** may flag the battery cell **26** as "COUNTERFEIT" or "ORIGINAL". More sophisticated information may alternatively be provided, such as indications of nominal and/or statistical values, such as specific voltage or current values during operation of the battery cell **26,** where said battery cell **26** deviates from an expected behaviour according to the corresponding behaviour of a selected reference battery cell among the plurality of reference battery cells **76.** The counterfeit characteristics data **90** may be reported to, for instance, the centralized server unit **50** for further assessment of the battery cell **26** being flagged as counterfeited.

The comparison is carried out by a battery cell modeler **70.** The battery cell modeler **70** is preferably implemented by the cloud-based computing resource **40** as discussed with reference to **FIG. 1****,** for instance using any of the above-mentioned cloud-computing technologies. Alternatively, the battery cell modeler **70** may be implemented by in-vehicle electronics, such as an internal vehicle controller or other microprocessor unit. The battery cell modeler **70** is configured to compare the battery reference data **72** and the sensor-obtained battery data **60** by employing data processing techniques.

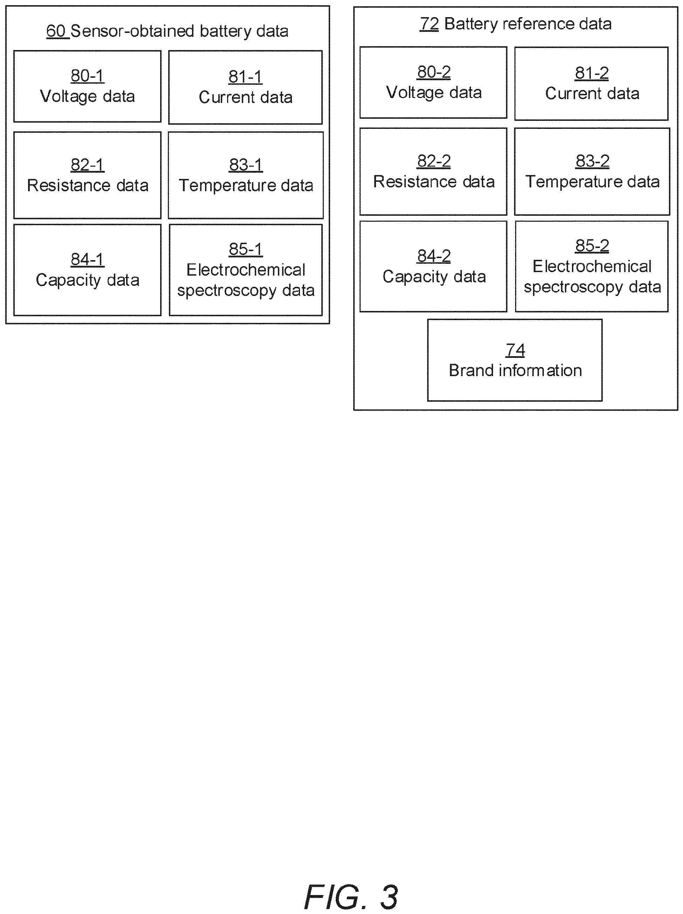

**FIG. 3** shows exemplary sensor-obtained battery data **60** and battery reference data **72.** Generally, the data **60, 72** is indicative of collections of data points of a respective battery cell, and said data points may be compared to one another for identifying deviations there between. The list of data shown in **FIG. 3** is not to be construed as limiting to the scope of the present disclosure. Rather, this data is merely exemplary types of data that can be compared to one another for identifying deviations therebetween. The data **60, 72** comprises voltage data **80-1, 80-2**, current data **81-1, 81-2**, resistance data **82-1, 82-2**, temperature data **83-1, 83-2**, capacity data **84-1, 84-2** and electrochemical spectroscopy data **85-1, 85-2**, respectively. To this end, one type of data point of the sensor-obtained battery data **60** is typically compared against a corresponding type of data point of the battery reference data **72**, e.g., voltage data points against other voltage data points, current data points against other current data points, resistance data points against other resistance data points, and so forth. The voltage data **80-1, 80-2** indicates the voltage of the associated battery cell. The current data **81-1, 81-2** indicates the current of the associated battery cell. The resistance data **82-1, 82-2** indicates the resistance of the associated battery cell. The temperature data **83-1, 83-2** indicates the temperature of the associated battery cell. The capacity data **84-1, 84-2** indicates the capacity of the associated battery cell. The capacity is the total amount of electricity generated due to electrochemical reactions in the battery over time. The electrochemical spectroscopy data **85-1, 85-2** may include electrochemical impedance spectroscopy (EIS) data. The EIS data may be measured by applying a potential wave to the working electrode of the battery cell and recording the resulting current wave, and obtaining a spectrum by measuring wave parameters with different frequencies in the applied waves.

In some examples, the comparison data points may be defined by ranges of comparison data points. It shall therefore be understood that some battery cells are adapted to operate between a first data point value and a second data point value, the second data point value being higher than the first data point value, and still be interpreted as one type of battery cell. By way of example, a window of 4 V to 6 V may correspond to a particular type of battery cell, whereas a window of 4.5 V to 5.5 V may correspond to another type of battery cell, whereas a window of 5 V to 8 V may correspond to a third type of battery cell. Other ranges may apply. To this end, ranges of any of the data depicted in **FIG. 3** may be comparable to identify potential counterfeit cells.

Further seen in **FIG. 3** is brand information **74** of the battery reference data **72.** Instead of or in addition to the data **80-2, 81-2, 82-2, 83-2, 84-2, 85-2,** the battery reference data **72** stored by the battery cell modeler may include additional information pertaining to what brand(s) the reference battery cells **76** is/are associated with. A particular brand may have a predetermined setting of data points and conditions in which said reference battery cells 76 are adapted to operate in. By comparing the sensor-obtained battery data **60** to said predetermined setting of data points and conditions, the battery cell modeler may be configured to identify that brand the battery cell **26** is associated with, thereby identifying deviations of said counterfeit characteristics data **90.**

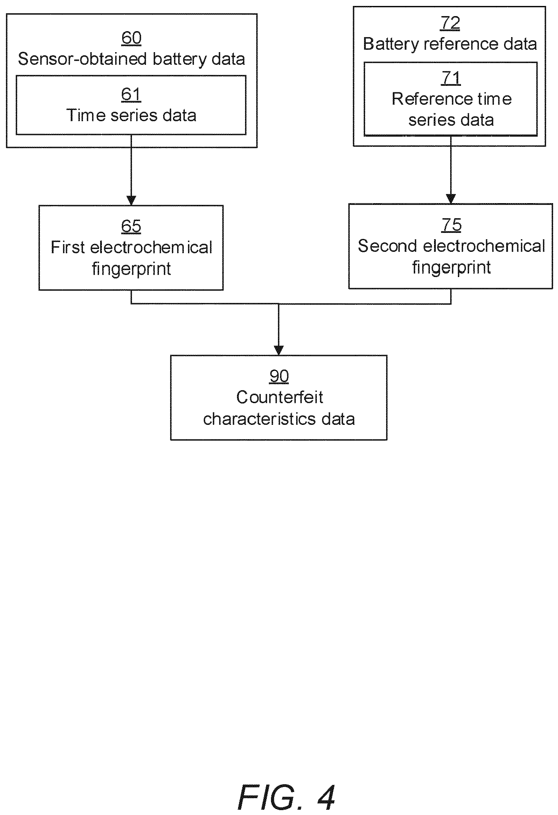

**FIG. 4** shows an exemplary approach of determining the counterfeit characteristics data **90.** The acts of **FIG. 4** are carried out in response to the battery cell modeler processing data. The battery cell modeler is configured to carry out the processing steps by performing time series analyses with respect to the sensor-obtained battery data **60** and the battery reference data **72,** respectively. Time series analyses refer to the process of obtaining data points over time being indicative of behaviour and/or performance of the object in which said data points are obtained from, which in this case is the battery cell **26** as well as the reference battery cells **76.** Exemplary data points can be collected as either one of the data types as discussed above with reference to **FIG. 3****.**

The processing of the data **60, 72** may comprise performing a time series analysis on time series data **61** included in the sensor-obtained battery data **60,** i.e., analyzing the data points of the sensor-obtained battery data **60** over a predetermined period of time. The time series analysis may comprise creating a first electrochemical fingerprint **65** of the time series data **61,** and creating a second electrochemical fingerprint **75** based on reference time series data **71** included in the battery reference data **72** of the reference battery cell being the comparison object. To this end, the second electrochemical fingerprint **75** of the comparison object (reference battery cell of a selected type) is correlated to the sensor-obtained battery data **60** of the battery cell **26** being used to create the first electrochemical fingerprint **65.** The electrochemical fingerprints **65, 75** may thus be compared to one another for determining the counterfeit characteristics data **90.**

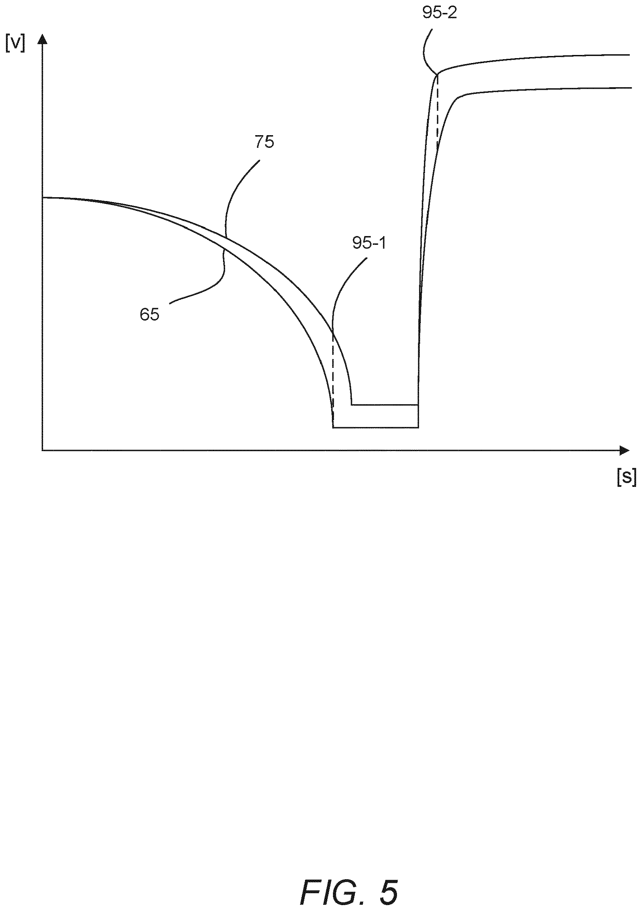

Since the first electrochemical fingerprint **65** is created using time series data **61** of the sensor-obtained battery data **60** of a battery cell, the first electrochemical fingerprint **65** may reflect any property based on the types of battery data **60** as shown and explained in **FIG. 3****.** Such properties may be electrochemical properties, open circuit voltage (OCV) curve data (including hysteresis, amplitude, frequency, etc.), state of charge (SoC), state of health (SoH), one data type in relation to another (e.g., cell resistance in relation to cell temperature), temperature changes, and so forth. The counterfeit characteristics data **90** may identify both potentially counterfeited cells, as well as replaced cells (no matter whether they are fraudulently replaced or not). In some examples, the comparison of the electrochemical fingerprints **65, 75** may involve detecting deviations that exceed a predefined threshold value. One such example is shown in **FIG. 5****.**

**FIG. 5** shows an exemplary approach of comparing the first and second electrochemical fingerprints **65, 75.** In this particular example, the electrochemical fingerprints **65, 75** are respectively created by analyzing voltage [v] time series data over time [s], although alternative variations are clearly possible. As indicated in the illustration, the first and second electrochemical fingerprints **65, 75** differ slightly. However, at two particular points in time, **95-1** and **95-2,** the first and second electrochemical fingerprints **65, 75** differ to an extent such that the deviations exceed a predefined threshold value. This may be an indication that the sensor-obtained battery data does not correlate to expected reference battery data, the counterfeit characteristics data **90** thereby indicating that the battery cell is a counterfeited battery cell.

In some examples, the counterfeit characteristics data **90** may be based on a plurality of determined and compared electrochemical fingerprints. Adding further conditions to determine a deviation may increase the accuracy of the identification procedure. By way of example, the voltage time series analysis as depicted in **FIG. 5** may be complemented with a corresponding capacity time series analysis, and potential deviations may require both of the analyses to respectively exceed a predefined threshold value in order to establish a potential counterfeited battery cell. Alternatively, one of the time series analyses may be associated with a predefined threshold value that differ from the predefined threshold value of the other time series analysis depending on operating conditions. Any such additional and/or alternative considerations may be taken into account depending on the circumstances surrounding the determination of the counterfeit characteristics data **90.**

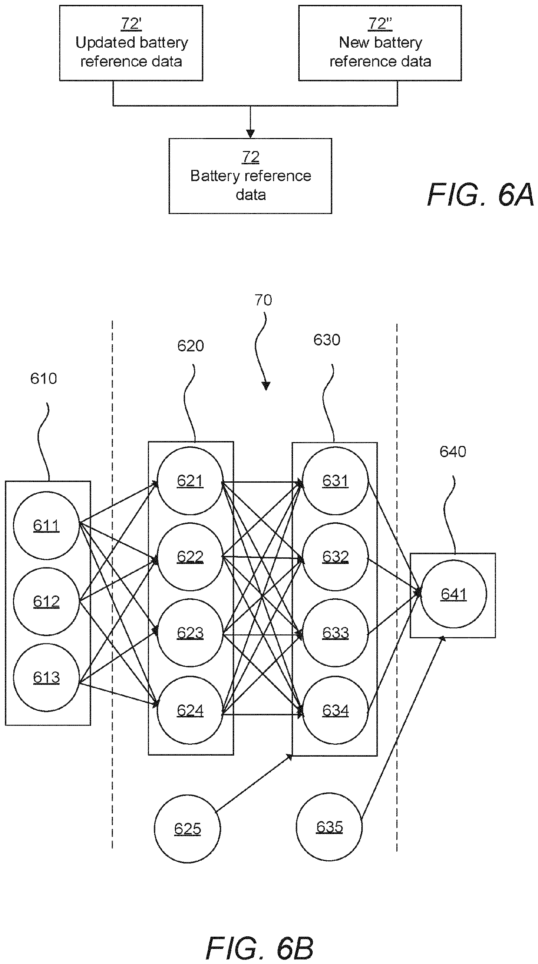

FIGs. 6A-B show an exemplary battery cell modeler **70** and associated data used by the modeler **70** to determine counterfeit characteristics data. The battery cell modeler **70** is in this example a neural network which is configured to employ machine learning approaches. The neural network is configured to periodically receive input data. The input data comprises updated battery reference data **72'** of already stored types of reference battery cells. The input data further comprises new battery cell data **72"** from additional different types of reference battery cells that have not yet been encountered by the neural network. The neural network is configured to perform a training procedure by processing the periodically received input data. The neural network is configured to determine the counterfeit characteristics data **90** taking into account the training procedure. Hence, the accuracy in determining potential counterfeited battery cells may be improved by the trained neural network. The trained neural network is capable of providing an intelligent identification based on previous identifications of potentially counterfeited battery cells. During use, the neural network may be configured to mark correct and/or incorrect identifications to further take into account when performing additional identification procedures so as to learn from previous behaviour, ultimately improving its accuracy. To this end, the neural network comprises self-learning features. Although being a neural network in this particular example, the battery cell modeler **70** may alternatively employ other supervised or unsupervised learning algorithms known in the art, such as binary, multi-class, or multi-label classification and/or clustering algorithms. For instance, algorithms such as logistic regression, support vector machines, kernel estimation, or decision trees may be utilized.

The battery cell modeler **70** being a neural network is shown according to one example in **FIG. 6B****.** The neural network is exemplified as having an input layer **610,** two hidden layers **620, 630,** and an output layer **640.** The input layer **610** comprises three nodes **611, 612, 613,** the first hidden layer **620** comprises four nodes **621, 622, 623, 624**, the second hidden layer **630** comprises four nodes **631, 632, 633, 634** and the output layer **640** comprises one node **641.** Moreover, the neural network comprises two weight nodes **625, 635**, each being associated with a respective hidden layer **620, 630.** The skilled person appreciates that this is just an exemplary neural network that can be implemented as the battery cell modeler **70.** Other networks may include any suitable number of input nodes, any suitable number of hidden layers and associated hidden nodes, any suitable number of output nodes, and any suitable number of weight nodes. The neural network may implement backpropagation for training purposes such that its performance of identifying potential counterfeit battery cells may be improved. The input nodes **611, 612, 613** may receive the input data as discussed above. The output node **641** may output the counterfeit characteristics data **90** as a result of the processing of the input data by the hidden layers **620, 630** and associated weight nodes **625, 635.**

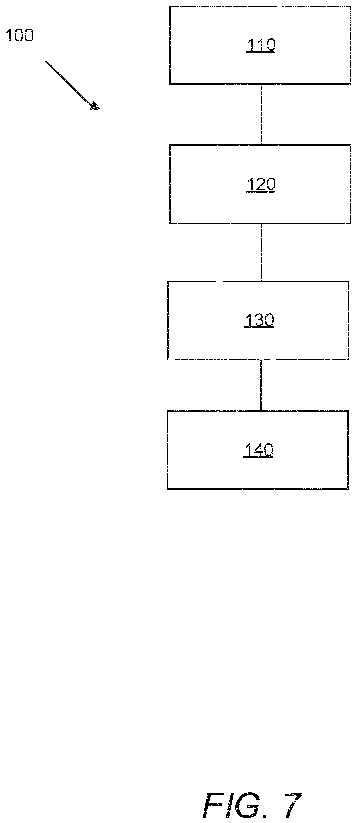

**FIG. 7** is a flowchart of a method **100** for vehicle battery cell counterfeit detection according to one example. The method **100** comprises receiving **110** sensor-obtained battery data from at least one battery cell being monitored by a battery management system of a vehicle, the at least one battery cell being of a particular type. The method **100** further comprises obtaining **120** battery reference data from a plurality of battery reference cells of different types. The method **100** further comprises comparing **130** the sensor-obtained battery data to the battery reference data, wherein the comparing **130** is performed by a battery cell modeler being configured to process the sensor-obtained battery data and the battery reference data. The method **100** further comprises, based on the comparing **130**, determining **140**, by the processing circuitry, counterfeit characteristics data indicating that said particular type of the at least one battery cell deviates from a selected type among said plurality of reference battery cells of different types.

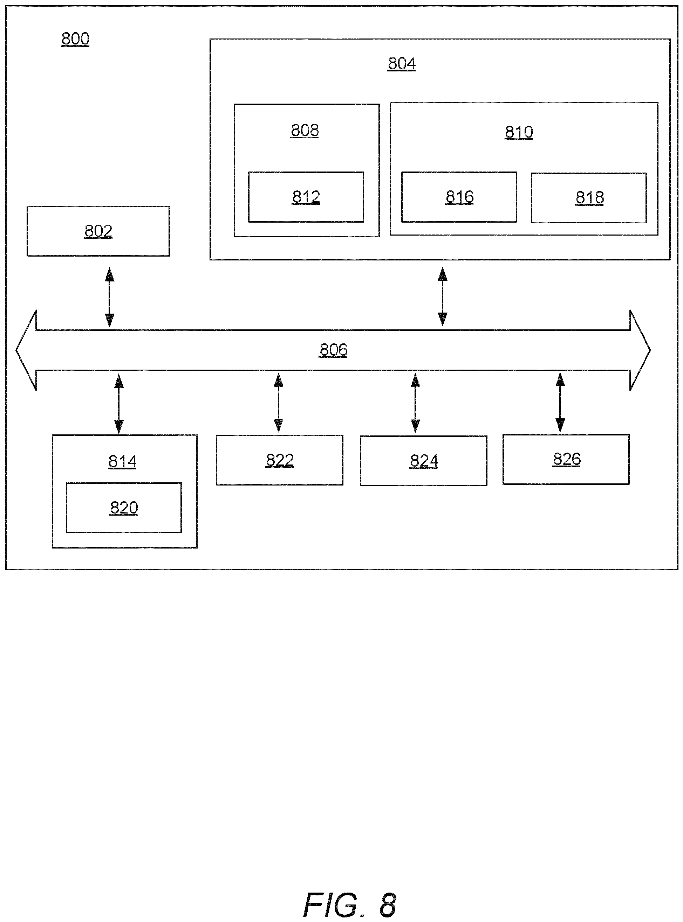

**FIG. 8** is a schematic diagram of a computer system **800** for implementing examples disclosed herein. The computer system **800** is adapted to execute instructions from a computer-readable medium to perform these and/or any of the functions or processing described herein. The computer system **800** may be connected (e.g., networked) to other machines in a LAN, an intranet, an extranet, or the Internet. While only a single device is illustrated, the computer system **800** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **800** may comprise at least one computing device or electronic device capable of including firmware, hardware, and/or executing software instructions to implement the functionality described herein. The computer system **800** may include processing circuitry **802** (e.g., processing circuitry including one or more processor devices or control units), a memory **804**, and a system bus **806.** The computer system **800** may include at least one computing device having the processing circuitry **802.** The system bus **806** provides an interface for system components including, but not limited to, the memory **804** and the processing circuitry **802.** The processing circuitry **802** may include any number of hardware components for conducting data or signal processing or for executing computer code stored in memory **804.** The processing circuitry **802** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **802** may further include computer executable code that controls operation of the programmable device.

The system bus **806** may be any of several types of bus structures that may further interconnect to a memory bus (with or without a memory controller), a peripheral bus, and/or a local bus using any of a variety of bus architectures. The memory **804** may be one or more devices for storing data and/or computer code for completing or facilitating methods described herein. The memory **804** may include database components, object code components, script components, or other types of information structure for supporting the various activities herein. Any distributed or local memory device may be utilized with the systems and methods of this description. The memory **804** may be communicably connected to the processing circuitry **802** (e.g., via a circuit or any other wired, wireless, or network connection) and may include computer code for executing one or more processes described herein. The memory **804** may include non-volatile memory **808** (e.g., read-only memory (ROM), erasable programmable read-only memory (EPROM), electrically erasable programmable read-only memory (EEPROM), etc.), and volatile memory **810** (e.g., random-access memory (RAM)), or any other medium which can be used to carry or store desired program code in the form of machine-executable instructions or data structures and which can be accessed by a computer or other machine with processing circuitry **802.** A basic input/output system (BIOS) **812** may be stored in the non-volatile memory **808** and can include the basic routines that help to transfer information between elements within the computer system **800.**

The computer system **800** may further include or be coupled to a non-transitory computer-readable storage medium such as the storage device **814**, which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **814** and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device **814** and/or in the volatile memory **810**, which may include an operating system **816** and/or one or more program modules **818.** All or a portion of the examples disclosed herein may be implemented as a computer program **820** stored on a transitory or non-transitory computer-usable or computer-readable storage medium (e.g., single medium or multiple media), such as the storage device **814,** which includes complex programming instructions (e.g., complex computer-readable program code) to cause the processing circuitry **802** to carry out actions described herein. Thus, the computer-readable program code of the computer program **820** can comprise software instructions for implementing the functionality of the examples described herein when executed by the processing circuitry **802.** In some examples, the storage device **814** may be a computer program product (e.g., readable storage medium) storing the computer program **820** thereon, where at least a portion of a computer program **820** may be loadable (e.g., into a processor) for implementing the functionality of the examples described herein when executed by the processing circuitry **802.** The processing circuitry **802** may serve as a controller or control system for the computer system **800** that is to implement the functionality described herein.

The computer system **800** may include an input device interface **822** configured to receive input and selections to be communicated to the computer system **800** when executing instructions, such as from a keyboard, mouse, touch-sensitive surface, etc. Such input devices may be connected to the processing circuitry **802** through the input device interface **822** coupled to the system bus **806** but can be connected through other interfaces, such as a parallel port, an Institute of Electrical and Electronic Engineers (IEEE) 1394 serial port, a Universal Serial Bus (USB) port, an IR interface, and the like. The computer system **800** may include an output device interface **824** configured to forward output, such as to a display, a video display unit (e.g., a liquid crystal display (LCD) or a cathode ray tube (CRT)). The computer system **800** may include a communications interface **826** suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. Although a specific order of method actions may be shown or described, the order of the actions may differ. In addition, two or more actions may be performed concurrently or with partial concurrence.

Example 1: A computer system comprising processing circuitry configured to receive sensor-obtained battery data from at least one battery cell being monitored by a battery management system of a vehicle, the at least one battery cell being of a particular type; obtain battery reference data from a plurality of battery reference cells of different types; compare the sensor-obtained battery data to the battery reference data, wherein a battery cell modeler is configured to perform the comparing by processing the sensor-obtained battery data and the battery reference data; and based on the comparing, determine counterfeit characteristics data indicating that said particular type of the at least one battery cell deviates from a selected type among said plurality of reference battery cells of different types.

Example 2: The system of example 1, wherein said processing of the sensor-obtained battery data and the battery reference data comprises performing a time series analysis on time series data included in the sensor-obtained battery data.

Example 3: The system of example 2, wherein the time series analysis comprises: creating a first electrochemical fingerprint based on the time series data included in the sensor-obtained battery data, creating a second electrochemical fingerprint based on reference time series data included in the battery reference data of said selected type among said plurality of reference battery cells of different types, said selected type being correlated to the at least one battery cell from which the sensor-obtained battery data was obtained, and comparing the first and second electrochemical fingerprints.

Example 4: The system of example 3, wherein the comparing of the first and second electrochemical fingerprints comprises detecting deviations exceeding a predefined threshold value.

Example 5: The system of any of the examples 1-4, wherein the battery cell modeler is a neural network.

Example 6: The system of example 5, wherein the neural network is configured to: periodically receive input data, the input data comprising updated battery reference data of already stored types of said reference battery cells, and new battery reference data from additional different types of reference battery cells, perform a training procedure by processing the periodically received input data, and determine the counterfeit characteristics data taking into account said performed training procedure.

Example 7: The system of example 6, wherein the updated battery reference data and the new battery reference data are periodically received from sample counterfeit cells.

Example 8: The system of any of the examples 1-7, wherein the battery reference data comprises brand information indicating what brand the reference battery cells of different types are associated with.

Example 9: The system of any of the examples 1-8, wherein each one of the sensor-obtained battery data and the battery reference data, respectively, is selected from a group comprising voltage data, current data, resistance data, temperature data, capacity data and electrochemical spectroscopy data.

Example 10: The system of any of the examples 1-9, wherein the battery cell modeler is comprised in a cloud-based computing resource external to the vehicle.

Example 11: The system of example 10, wherein the cloud-based computing resource is configured to transmit the counterfeit characteristics data to either one or both of a vehicle telematics unit arranged in the vehicle and a central server.

Example 12: A vehicle comprising the computer system of any of the examples 1-11.

Example 13: A computer-implemented method for vehicle battery cell counterfeit detection, comprising: receiving, by processing circuitry of a computer system, sensor-obtained battery data from at least one battery cell being monitored by a battery management system of a vehicle, the at least one battery cell being of a particular type; obtaining, by the processing circuitry, battery reference data from a plurality of battery reference cells of different types; comparing , by the processing circuitry, the sensor-obtained battery data to the battery reference data, wherein the comparing is performed by a battery cell modeler being configured to process the sensor-obtained battery data and the battery reference data; and based on the comparing, determining, by the processing circuitry, counterfeit characteristics data indicating that said particular type of the at least one battery cell deviates from a selected type among said plurality of reference battery cells of different types.

Example 14: A computer program product comprising program code for performing, when executed by the processing circuitry, the method of example 13.

Example 15: A non-transitory computer-readable storage medium comprising instructions, which when executed by the processing circuitry, cause the processing circuitry to perform the method of example 13.

Example 16: The system of example 9, wherein the spectroscopy data includes electrochemical impedance spectroscopy data.

Example 17: The system of any of the examples 1-11, wherein single points of the sensor-obtained battery data and the battery reference data are compared.

Example 18: The system of any of the examples 1-11, wherein ranges comprising a first endpoint and a second endpoint defining said ranges of the sensor-obtained battery data and the battery reference data are compared.

Example 19: The system of example 10, wherein the cloud-based computing resource comprises a cloud-based storage unit configured to store data used by the battery cell modeler.

Example 20: The system of example 11, wherein the vehicle telematics unit and the cloud-based computing resource are configured to communicate using one or more network/radio communication protocols.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

## Claims

1. A computer system comprising processing circuitry configured to:
receive sensor-obtained battery data (60) from at least one battery cell (26) being monitored by a battery management system (20) of a vehicle (10), the at least one battery cell (26) being of a particular type;
obtain battery reference data (72) from a plurality of battery reference cells (76) of different types;
compare the sensor-obtained battery data (60) to the battery reference data (72), wherein a battery cell modeler (70) is configured to perform the comparing by processing the sensor-obtained battery data (60) and the battery reference data (72); and
based on the comparing, determine counterfeit characteristics data (90) indicating that said particular type of the at least one battery cell (26) deviates from a selected type among said plurality of reference battery cells (76) of different types.

2. The computer system of claim 1, wherein said processing of the sensor-obtained battery data (60) and the battery reference data (72) comprises performing a time series analysis on time series data (61) included in the sensor-obtained battery data (60).

3. The computer system of claim 2, wherein the time series analysis comprises:
creating a first electrochemical fingerprint (65) based on the time series data (61) included in the sensor-obtained battery data (60),
creating a second electrochemical fingerprint (75) based on reference time series data (71) included in the battery reference data (72) of said selected type among said plurality of reference battery cells (76) of different types, said selected type being correlated to the at least one battery cell (26) from which the sensor-obtained battery data (60) was obtained, and
comparing the first and second electrochemical fingerprints (65, 75).

4. The computer system of claim 3, wherein the comparing of the first and second electrochemical fingerprints (65, 75) comprises detecting deviations exceeding a predefined threshold value.

5. The computer system of any of claims 1-4, wherein the battery cell modeler (70) is a neural network.

6. The computer system of claim 5, wherein the neural network is configured to:
periodically receive input data, the input data comprising updated battery reference data (72') of already stored types of said reference battery cells (76), and new battery reference data (72") from additional different types of reference battery cells (76),
perform a training procedure by processing the periodically received input data, and
determine the counterfeit characteristics data (90) taking into account said performed training procedure.

7. The computer system of claim 6, wherein the updated battery reference data (72') and the new battery reference data (72") are periodically received from sample counterfeit cells.

8. The computer system of any preceding claim, wherein the battery reference data (72) comprises brand information (74) indicating what brand the reference battery cells (76) of different types are associated with.

9. The computer system of any preceding claim, wherein each one of the sensor-obtained battery data (60) and the battery reference data (72), respectively, is selected from a group comprising voltage data (80), current data (81), resistance data (82), temperature data (83), capacity data (84) and electrochemical spectroscopy data (85).

10. The computer system of any preceding claim, wherein the battery cell modeler (70) is comprised in a cloud-based computing resource (40) remote from the vehicle (10).

11. The computer system of claim 10, wherein the cloud-based computing resource (40) is configured to transmit the counterfeit characteristics data (90) to either one, or both, of a vehicle telematics unit (30) arranged in the vehicle (10) and a central server (50).

12. A vehicle comprising the computer system of any of claims 1-11.

13. A computer-implemented method (100) for vehicle battery cell counterfeit detection, comprising:
receiving (110), by processing circuitry of a computer system, sensor-obtained battery data (60) from at least one battery cell (26) being monitored by a battery management system (20) of a vehicle (10), the at least one battery cell (26) being of a particular type;
obtaining (120), by the processing circuitry, battery reference data (72) from a plurality of battery reference cells (76) of different types;
comparing (130), by the processing circuitry, the sensor-obtained battery data (60) to the battery reference data (72), wherein the comparing (130) is performed by a battery cell modeler (70) being configured to process the sensor-obtained battery data (60) and the battery reference data (72); and
based on the comparing (130), determining (140), by the processing circuitry, counterfeit characteristics data (90) indicating that said particular type of the at least one battery cell (26) deviates from a selected type among said plurality of reference battery cells (76) of different types.

14. A computer program product comprising program code for performing, when executed by the processing circuitry, the method (100) of claim 13.

15. A non-transitory computer-readable storage medium comprising instructions, which when executed by the processing circuitry, cause the processing circuitry to perform the method (100) of claim 13.
